(19) Europäisches Patentamt

European Patent Office

Office européen des brevets

(11) **EP 0 527 641 B1**

(12) **EUROPEAN PATENT SPECIFICATION**

(45) Date of publication and mention
of the grant of the patent:
**19.11.1997 Bulletin 1997/47**

(51) Int Cl.⁶: **H02P 7/00**

(21) Application number: **92307378.7**

(22) Date of filing: **12.08.1992**

(54) **H-bridge flyback recirculator**

H-Brücken-Freilauf-Rückführung

Recirculateur pour pont en H

(84) Designated Contracting States:
**DE FR GB**

(30) Priority: **12.08.1991 US 743955**
**14.01.1992 FR 9200319**

(43) Date of publication of application:
**17.02.1993 Bulletin 1993/07**

(73) Proprietor: **MOTOROLA, INC.**
**Schaumburg, IL 60196 (US)**

(72) Inventors:
• **Pigott, John M.**
**Phoenix, Arizona 85044 (US)**
• **Jarret, Robert B.**
**Tempe, Arizona 85284 (US)**
• **Nguyen, Xuan Quang**
**F-31320 Cassin, Castanet (FR)**

(74) Representative: **Hudson, Peter David et al**
**Motorola,**
**European Intellectual Property Operations,**
**Midpoint**
**Alencon Link**
**Basingstoke, Hampshire RG21 7PL (GB)**

(56) References cited:
**EP-A- 0 104 851          EP-A- 0 160 896**
**US-A- 4 545 004**

• **ELECTRO, vol. 11, no. 10/3, 1986, Los Angeles US, pp. 1-7; R.A. BLANCHARD et al.: 'Low-on-resistance, low-voltage power Mosfets for motor-drive applications'**

## Description

Field of the Invention

This invention relates to circuits, for example, an H-bridge flyback recirculator circuit.

An inductive load is typically coupled across first and second output terminals of an H-bridge circuit. The H-bridge circuit alternately supplies current through the inductive load in a first and a second polarity in response to an applied control signal. That is, when the control signal is in a first state, current flows from the first output terminal, through the inductive load, to the second output terminal. Further, when the control signal is in a second state, current flows from the second output terminal, through the inductive load, to the first output terminal. However, when switching the current polarity through the inductive load, if the energy stored in the inductive load is not allowed to decay in a controlled fashion, the voltage at the first or second, or both, output terminals of the H-bridge circuit will rapidly increase, as is well known.

One attempt at controlling the current discharge through an inductive load of an H-bridge circuit entails utilizing reverse connected diodes coupled across each switch of the H-bridge circuit. However, in an integrated circuit, this attempt may cause undesired injection of carriers into the substrate which can affect the operation of other circuits.

Another attempt at controlling the current discharge through an inductive load of an H-bridge circuit entails utilizing a timer circuit that is rendered conductive at the proper time in order to clamp the voltage appearing at the first and second output terminals of the H-bridge circuit to predetermined values. However, this attempt requires a knowledge of the drive signals and of the characteristics of the inductive load for optimal operation.

U.S. Patent No. 4,545,004 discloses transistor bridge driver circuitry for DC motor controllers. More particularly, this patent provides drive circuitry capable of operating in a one quadrant control mode or a two quadrant control mode. In the one quadrant control mode, one of the power transistors is maintained conductive and a diagonally opposed power transistor is maintained conductive and nonconductive to effectively connect and disconnect the motor winding and the power source. Further, the power source supplies current in one direction only. In the two quadrant control mode, the diagonally opposed power transistors are biased conductive and nonconductive in unison and inductive current stored in the motor windings when the power transistors are biased nonconductive is circulated through the power source via two freewheeling diodes. Thus, the power source supplies/accepts current in two directions. The drive circuitry operates a power transistor bridge in the one quadrant control mode to take advantage of the relatively low switching losses associated therewith, while limiting the driver circuit losses substantially to those incurred with the two quadrant control mode.

There exists a need to provide an improved circuit for controlling the current discharge through an inductive load of an H-bridge circuit.

Summary of the Invention

In accordance with the present invention there is provided an H-bridge circuit comprising:

at least four transistors, each transistor having a control electrode and first and second current carrying electrodes, the control electrodes of a first transistor and a second transistor of the at least four transistors responsive to first and second control signals, respectively, the first current carrying electrodes of the first and second transistors coupled for receiving a first supply voltage, the second current carrying electrode of the first transistor coupled to the first current carrying electrode of a third transistor of the at least four transistors, the second current carrying electrode of the second transistor coupled to the first current carrying electrode of a fourth transistor of the at least four transistors, the second current carrying electrodes of the third and fourth transistors coupled for receiving a second supply voltage, the second current carrying electrode of the first transistor coupled to the second current carrying electrode of the second transistor through an inductive load, the second current carrying electrode of the second transistor serving as a first output terminal and the second current carrying electrode of the first transistor serving as a second output terminal;

a first circuit coupled to the second output terminal for clamping the second output terminal to a predetermined voltage, the first circuit providing current drive to the fourth transistor thereby creating a first recirculation path to discharge the inductive load; and

a second circuit coupled to the first output terminal for clamping the first output terminal to a predetermined voltage, the second circuit providing current drive to the third transistor thereby creating a second recirculation path to discharge the inductive load, the H-bridge circuit being characterized by:

the first circuit including a fifth transistor having first, second, and third current carrying electrodes, and a control electrode, the first current carrying electrode of the fifth transistor coupled to the second output terminal, the second current carrying electrode of the fifth transistor coupled to the control electrode of the fourth transistor, and the third current carrying electrode of the fifth transistor coupled to the control electrode of the fifth transistor.

The present invention will be better understood from the following detailed description taken in conjunction with the accompanying drawings.

Brief Description of the Drawings

FIG. 1 is a detailed schematic diagram illustrating a first H-bridge circuit in accordance with the present invention;
FIG. 2 is a graphical diagram illustrating signals appearing at selected nodes of the H-bridge circuit of FIG. 1; and
FIG. 3 is a schematic diagram illustrating a second H-bridge circuit in accordance with the present invention.

Detailed Description of the Drawings

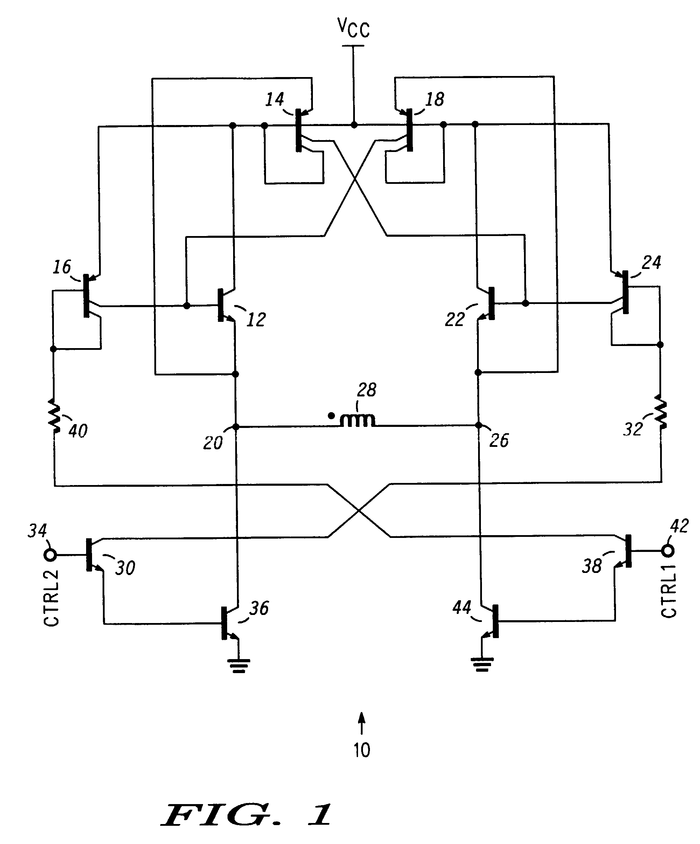

Referring to FIG. 1, the detailed schematic diagram illustrating H-bridge circuit 10 is shown comprising transistor 12 having a collector coupled to the base of transistor 14 and to the emitter of transistor 16. The collector of transistor 12 is also coupled to receive operating potential $V_{CC}$. The base of transistor 12 is coupled to a first collector of transistor 16 and to a first collector of transistor 18. The emitter of transistor 12 is coupled to the emitter of transistor 14 and to circuit node 20 whereby circuit node 20 represents a first output of H-bridge circuit 10.

Transistor 22 has a collector coupled to the base of transistor 18 and to the emitter of transistor 24. The collector of transistor 22 is also coupled to receive operating potential $V_{CC}$. The base of transistor 22 is coupled to the first collector of transistor 24 and to the first collector of transistor 14. The emitter of transistor 22 is coupled to the emitter of transistor 18 and to circuit node 26 whereby circuit node 26 represents a second output of H-bridge circuit 10.

The second collectors of transistors 14 and 18 are respectively coupled to the bases of transistors 14 and 18. Likewise, the second collectors of transistors 16 and 24 are respectively coupled to the bases of transistors 16 and 24.

Inductive load 28 is coupled across circuit nodes 20 and 26.

Transistor 30 has a collector coupled through resistor 32 to the base of transistor 24. The base of transistor 30 is coupled to terminal 34 at which signal CTRL2 is applied. The emitter of transistor 30 is coupled to the base of transistor 36, the latter having an emitter returned to ground. The collector of transistor 36 is coupled to circuit node 20.

Transistor 38 has a collector coupled through resistor 40 to the base of transistor 16. The base of transistor 38 is coupled to terminal 42 at which signal CTRL1 is applied. The emitter of transistor 38 is coupled to the base of transistor 44, the latter having an emitter returned to ground. The collector of transistor 44 is coupled to circuit node 26.

Switching transistors 12, 22, 36 and 44 form an H-bridge circuit wherein transistor pair 12 and 44 and transistor pair 22 and 36 are alternately rendered active via control signals CTRL1 and CTRL2. When signal CTRL1 is in a first logic state, for example, a logic high state, and signal CTRL2 is in a second logic state, a first half of H-bridge circuit 10 formed by transistors 12 and 44 is rendered conductive. Thus, current is provided in a first direction through inductive load 28 that flows from operating potential $V_{CC}$ through transistor 12, through inductive load 28 and through transistor 44 to ground.

On the other hand, when signal CTRL2 is in a first logic state and signal CTRL1 is in a second logic state, a second half of H-bridge circuit 10 formed by transistors 22 and 36 is rendered conductive. Thus, current is provided in a second direction through inductive load 28 that flows from operating potential $V_{CC}$ through transistor 22, through inductive load 28 and through transistor 36 to ground.

In operation, when signal CTRL1 applies a logic high voltage to the base of transistor 38, transistor 38 is rendered conductive and provides current to the base of transistor 44 thereby driving transistor 44 into saturation. Further, since transistor 38 is rendered conductive, current flows from operating potential $V_{CC}$ through transistor 16 and resistor 40, and through transistors 38 and 44. It is worth noting that transistor 16 is operating in the saturation region when transistor 38 is rendered conductive. Current then flows into the base of transistor 12 via the first collector of transistor 16, thereby rendering transistor 12 conductive. As a result, a first current path is created wherein current flows from operating potential $V_{CC}$ through transistor 12, through inductive load 28 (from circuit node 20 to 26), and returned to ground through transistor 44.

At this point, the voltage appearing at circuit node 20 ($V_{N20}$) can be expressed as shown in EQN. 1.

$$V_{N20} = V_{CC} - V_{SAT(Q16)} - V_{BE(Q12)} \qquad (1)$$

where

$V_{SAT(Q16)}$ is the saturation voltage of transistor 16; and
$V_{BE(Q12)}$ is the base emitter voltage of transistor 12.

Further, the voltage appearing at circuit node 26 ($V_{N26}$) is substantially equal to the saturation voltage of transistor 44 $\{V_{N26} = V_{SAT(Q44)}\}$.

However, when signal CTRL1 switches from a first logic state to a second logic state (a logic high state to a logic low state), transistor 38 is rendered non-conductive thereby rendering transistor 44 non-conductive. Since transistor 38 is non-conductive, transistor 16 is also non-conductive wherein the first collector of transistor 16 no longer provides current to the base of transistor 12. As a result, the first current path has been interrupted.

Since the current through inductive load 28 cannot change instantaneously, the voltage at circuit node 26 rapidly increases. However, the present invention provides a clamp, via transistor 18, such that the voltage at circuit node 26 is clamped to a predetermined voltage that is substantially equal to one diode voltage above operating potential $V_{CC}$. That is, as the voltage appearing at circuit node 26 increases to a predetermined voltage, transistor 18 turns on and clamps the voltage at circuit node 26 to a predetermined voltage substantially equal to $V_{CC} + V_{BE(Q18)}$.

Moreover, as transistor 18 turns on, the first collector of transistor 18 supplies a predetermined amount of the total collector current to the base of transistor 12 thereby maintaining transistor 12 conductive. As an example, the second collector of transistor 18 may be nine times the size of the first collector of transistor 18. Thus, if the total collector current of transistor 18 is 100 mA, then 10 mA flows through the first collector, while 90 mA flows through the second collector.

Thus, since transistor 12 is maintained conductive via the current supplied from the first collector of transistor 18, a first recirculation current path is completed which allows a controlled discharge of current through inductive load 28. In particular, the first recirculation path is formed by the closed loop of transistor 18, transistor 12 and inductive load 28.

Also during the switching of signal CTRL1 from a logic high voltage to a logic low voltage, the voltage appearing at circuit node 20 rises from its initial voltage as shown in EQN. 1, when current is still flowing through inductive load 28, to a saturation voltage below $V_{CC}$ as shown in EQN. 2.

$$V_{N20} = (V_{CC} + V_{BE(Q18)}) - V_{SAT(Q18)} - V_{BE(Q12)} = V_{CC} - V_{SAT(Q18)} \qquad (2)$$

where EQN. 2 assumes that the base emitter voltages of transistors 12 and 18 are substantially equal.

The first recirculation path allows the voltages appearing at circuit nodes 20 and 26 to approach a substantially equal value as the stored energy of inductive load 28 approaches zero.

In summary, the present invention utilizes transistor 18 to clamp circuit node 26 to a predetermined voltage. In addition, the first collector of transistor 18 also provides drive current to the base of transistor 12 to maintain transistor 12 conductive thereby completing a first recirculation path to allow the current of inductive load 28 to discharge at a controlled rate.

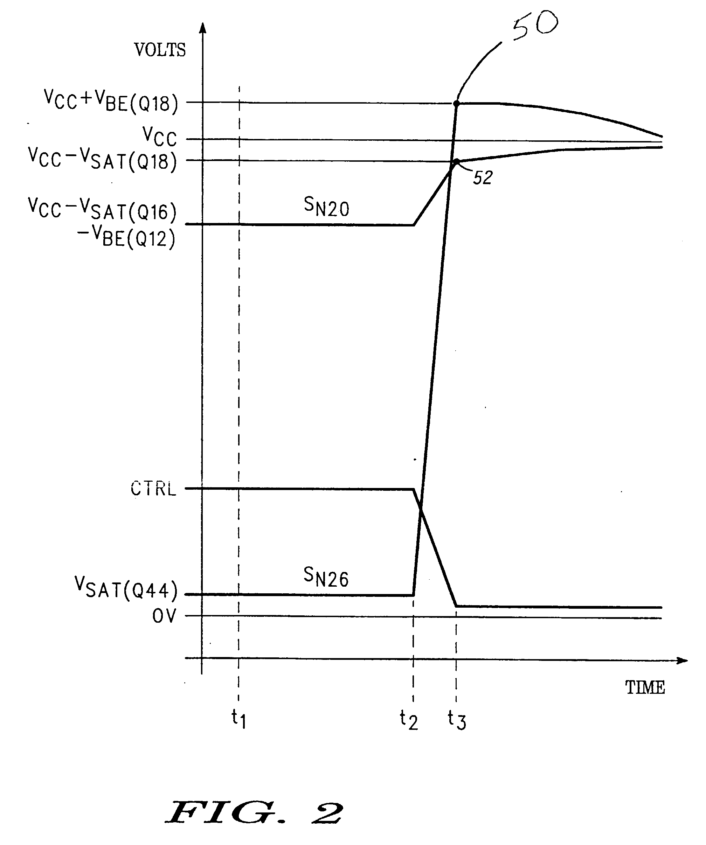

Referring to FIG. 2, the graphical diagram illustrating signals appearing at selected nodes of H-bridge circuit 10 of FIG. 1 is shown.

In particular, between time interval $t_1$ to $t_2$, signal CTRL1 is in a logic high state as shown by signal CTRL1. The signal appearing at circuit node 20, denoted by signal $S_{N20}$, is at the voltage substantially equal to $(V_{CC} - V_{SAT(Q16)} - V_{BE(Q12)})$ as expressed in EQN. 1. Further, the signal appearing at circuit node 26, denoted by signal $S_{N26}$, is shown to be at a voltage substantially equal to $V_{SAT(Q44)}$.

During time interval $t_2$ to $t_3$, signal CTRL1 switches from a logic high state to a logic low state. As aforedescribed, the voltage appearing at circuit node 26 rapidly increases to a diode voltage above voltage $V_{CC}$ as illustrated by reference number 50 of signal $S_{N26}$. In addition, the voltage appearing at circuit node 20 rises from its initial voltage as shown in EQN. 1, to a saturation voltage below voltage $V_{CC}$ as calculated in EQN. 2 and as illustrated by reference number 52 of signal $S_{N20}$.

From time $t_3$ up until transistor 30 or transistor 38 is rendered conductive, the first recirculation path as aforedescribed is active. Thus, the voltages appearing at circuit nodes 20 and 26 approach voltage $V_{CC}$ as the current flowing through inductive load 28 decays to zero.

Referring back to FIG. 1, it should be understood that transistor 14 operates in a similar manner as transistor 18 for the second (complementary) half of H-bridge circuit 10.

In particular, the second half of H-bridge circuit 10 includes transistors 22, 36, 30, 24 and 14 which are analogous to transistors 12, 44, 38, 16 and 18 of the aforedescribed first half of H-bridge circuit 10. In addition, resistor 32 is analogous to resistor 40. Thus, a detailed description for the operation of the second half of H-bridge circuit 10 is not included thereby avoiding redundancy.

Briefly, it is understood that transistor 14 clamps circuit node 20 to a predetermined voltage, while the first collector of transistor 14 provides a drive current to maintain transistor 22 conductive thereby allowing inductive load 28 to discharge at a controlled rate. Thus, a second recirculation path is formed by the closed loop of transistor 14, transistor 22 and inductive load 28.

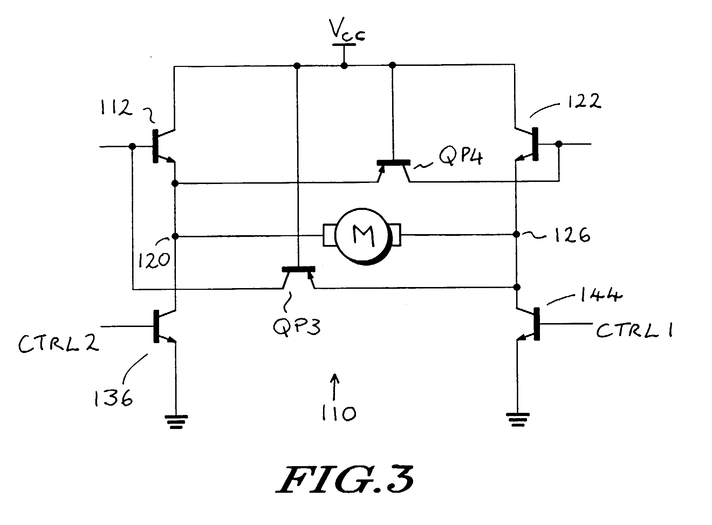

Referring now also to FIG. 3, a second H-bridge circuit 110 in accordance with the invention is similar to the first H-bridge circuit 10 (like components to those of FIG. 1 are referred to by the same reference numeral plus the number 100) except that the multi-collector transistors 14 and 18 are replaced by lateral pnp transistors QP3 and QP4 each having their bases coupled to Vcc and their emitter-collector paths connected between respectively the base of transistor 112 and the emitter of transistor 122 and the base of transistor 122 and the emitter of transistor 112. It should be noted that since QP3 and QP4 have only one collector, the entire collector currents flowing through QP3 and QP4 also respectively flow into the bases of transistors 112 and 122.

By now it should be appreciated from the foregoing discussion a novel circuit for discharging an inductive load of an H-bridge circuit at a controlled rate has been provided. The present invention provides a circuit to clamp one side of an inductive load, while utilizing the circuit to create a recirculation path to discharge the inductive load at a controlled rate.

While the invention has been described in conjunction with specific embodiments thereof, it is evident that many alterations, modifications and variations will be apparent to those skilled in the art in light of the foregoing description. Accordingly, it is intended to embrace all such alterations, modifications and variations in the appended claims.

## Claims

1. An H-bridge circuit (10) comprising:

   at least four transistors (44, 36, 22, 12), each transistor having a control electrode and first and second current carrying electrodes, the control electrodes of a first transistor (44) and a second transistor (36) of the at least four transistors (44, 36, 22, 12) responsive to first (CTRL1) and second (CTRL2) control signals, respectively, the first current carrying electrodes of the first (44) and second (36) transistors coupled for receiving a first supply voltage, the second current carrying electrode of the first transistor coupled to the first current carrying electrode of a third transistor (22) of the at least four transistors (44, 36, 22, 12), the second current carrying electrode of the second transistor (36) coupled to the first current carrying electrode of a fourth transistor (12) of the at least four transistors (44, 36, 22, 12), the second current carrying electrodes of the third (22) and fourth (12) transistors coupled for receiving a second supply voltage, the second current carrying electrode of the first transistor (44) coupled to the second current carrying electrode of the second transistor (36) through an inductive load (28), the second current carrying electrode of the second transistor (36) serving as a first output terminal (20) and the second current carrying electrode of the first transistor serving as a second output terminal (26); a first circuit coupled to the second output terminal (26) for clamping the second output terminal (26) to a predetermined voltage, the first circuit providing current drive to the fourth transistor (12) thereby creating a first recirculation path to discharge the inductive load (28); and a second circuit (14) coupled to the first output terminal (20) for clamping the first output terminal (20) to a predetermined voltage, the second circuit (14) providing current drive to the third transistor (22) thereby creating a second recirculation path to discharge the inductive load (28), the H-bridge circuit (10) being characterized by:
   the first circuit including a fifth transistor (18) having first, second, and third current carrying electrodes and a control electrode, the first current carrying electrode of the fifth transistor (18) coupled to the second output terminal (26), the second current carrying electrode of the fifth transistor (18) coupled to the control electrode of the fourth transistor (12), and the third current carrying electrode of the fifth transistor (18) coupled to the control electrode of the fifth transistor (18).

2. The H-bridge circuit (10) according to claim 1, wherein the second circuit includes a sixth transistor (14) having first, second, and third current carrying electrodes and a control electrode, the first current carrying electrode of the sixth transistor (14) coupled to the first output terminal (20), the second current carrying electrode of the sixth transistor (14) coupled to the control electrode of the third transistor (22), and the third current carrying electrode of the sixth transistor (14) coupled to the control electrode of the sixth transistor (14).

3. The H-bridge circuit (10) according to claim 2, wherein the first, second, third, and fourth transistors are NPN bipolar transistors, and the fifth and sixth transistors are PNP bipolar transistors.

## Patentansprüche

1. H-Brückenscahltung (10), welche aufweist:

   zumindest vier Transistoren (4, 36, 22, 12), wobei jeder Transistor eine Steuerelektrode und eine erste und zweite Stromführungselektrode aufweist, die Steuerelektroden eines ersten Transistors (44) und eines zweiten Transistors (36) der zumindest vier Transistoren (44, 26, 22, 12) auf ein erstes (CTRL1) und ein zweites (CTRLS2) Steuersignal ansprechen, wobei die ersten Stromführungselektroden des ersten (44) und zweiten (36) Transistors zum Empfang einer ersten Versorgungsspannung angeschlossen sind, die zweite Stromführungselektrode des ersten Transistors mit der ersten Stromführungselektrode eines dritten Transistors (22) der zumindest vier Transistoren (44, 36, 22, 12) verbunden ist, die zweite Stromführungselektrode des zweiten Transistors (36) mit der ersten Stromführungselektrode eines vierten Transistors (12) der zumindest vier Transistoren (44, 36, 22, 12) verbunden ist, die zweiten Stromführungselektroden des dritten (22) und vierten (12) Transistors zum Empfang einer zweiten Versorgungsspannung angeschlossen sind, die zweite Stromführungselektrode des ersten Transistors (44) mit der zweiten Stromführungselektrode des zweiten Transistors (36) über eine induktive Last (48) verbunden ist, die zweite Stromführungselektrode des zweiten Transistors (36) als erster Ausgangsanschluß (20) dient und die zweite Stromführungselektrode des ersten Transistors als zweiter Ausgangsanschluß (26) dient;

eine erste Schaltung, die mit dem zweiten Ausgangsanschluß (26) verbunden ist, zum Klammern des zweiten Ausgangsanschlusses (26) auf eine vorbestimmte Spannung, wobei die erste Schaltung eine Stromansteuerung für den vierten Transistor (12) liefert, um so einen ersten Rückführungsweg zur Entladung der induktiven Last (28) zu schaffen; und

eine zweite Schaltung (14), die mit dem ersten Ausgangsanschluß (20) verbunden ist, zum Klammern des ersten Ausgangsanschlusses (20) auf eine vorbestimmte Spannung, wobei die zweite Schaltung (14) eine Stromansteuerung für den dritten Transistor (22) liefert, um einen zweiten Rückführungsweg zur Entladung der induktiven Last (28) zu schaffen;

wobei die H-Brückenschaltung (10) dadurch gekennzeichnet ist, daß:

die erste Schaltung einen fünften Transistor (18) mit einer ersten, zweiten und dritten Stromführungselektrode sowie einer Steuerelektrode aufweist, wobei die erste Stromführungselektrode des fünften Transistors (18) mit dem zweiten Ausgangsanschluß (26) verbunden ist, die zweite Stromführungselektrode des fünften Transistors (18) mit der Steuerelektrode des vierten Transistors (12) verbunden ist und die dritte Stromführungselektrode des fünften Transistors (18) mit der Steuerelektrode des fünften Transistors (18) verbunden ist.

2. H-Brückenschaltung (10) gemäß Anspruch 1, dadurch gekennzeichnet, daß die zweite Schaltung einen sechsten Transistor (14) mit einer ersten, zweiten und dritten Stromführungselektrode sowie einer Steuerelektrode aufweist, wobei die erste Stromführungselektrode des sechsten Transistors (14) mit dem ersten Ausgangsanschluß (20) verbunden ist, die zweite Stromführungselektrode des sechsten Transistors (14) mit der Steuerelektrode des dritten Transistors (22) verbunden ist und die dritte Stromführungselektrode des sechsten Transistors (14) mit der Steuerelektrode des sechsten Transistors (14) verbunden ist.

3. H-Brückenschaltung (10) nach Anspruch 2, dadurch gekennzeichnet, daß der erste, zweite, dritte und vierte Transistor NPN-Bipolartransistoren sind und der fünfte und sechste Transistor PNP-Bipolartransistoren sind.

## Revendications

1. Circuit à pont en H (10) comprenant :

au moins quatre transistors (44, 36, 22, 12), chaque transistor possédant une électrode de commande et des première et deuxième électrodes de transport de courant, les électrodes de commande d'un premier transistor (44) et d'un deuxième transistor (36) parmi les quatre (au moins quatre) transistors (44, 36, 22, 12) répondant respectivement à des premier et deuxième signaux de commande (CTRL1 et CTRL2), les premières électrodes de transport de courant des premier et deuxième transistors (44 et 36) étant couplées de façon à recevoir une première tension d'alimentation, la deuxième électrode de transport de courant du premier transistor étant couplée à la première électrode de transport de courant d'un troisième transistor (22) des quatre (au moins quatre) transistors (44, 36, 22, 12), la deuxième électrode de transport de courant du deuxième transistor (36) étant couplée à la première électrode de transport de courant d'un quatrième transistor (12) des quatre (au moins quatre) transistors (44, 36, 22, 12), les deuxièmes électrodes de transport de courant des troisième et quatrième transistors (22 et 12) étant couplées de façon à recevoir une deuxième tension d'alimentation, la deuxième électrode de transport de courant du premier transistor (44) étant couplée à la deuxième électrode de transport de courant du deuxième transistor (36) via une charge inductive (28), la deuxième électrode de transport de courant du deuxième transistor (36) faisant fonction d'une première borne de sortie (20) et la deuxième électrode de transport de courant du premier transistor faisant fonction d'une deuxième borne de sortie (26) ; un premier circuit couplé à la deuxième de sortie (26) et servant à fixer le niveau de tension de la deuxième de sortie (26) sur une tension prédéterminée, le premier circuit fournissant une excitation de courant au quatrième transistor (12), de manière à créer un premier trajet de recirculation pour décharger la charge inductive (28) ; et un deuxième circuit (14) couplé à la première borne de sortie (20) et servant à fixer le niveau de tension de la première borne de sortie (20) sur une tension prédéterminée, le deuxième circuit (14) fournissant une excitation de courant au troisième transistor (22) de manière à créer un deuxième trajet de recirculation pour décharger la charge inductive (28),

le circuit à pont en H (10) étant caractérisé par le fait que :

le premier circuit comporte un cinquième transistor (18) qui possède des première, deuxième et troisième électrodes de transport de courant et une électrode de commande, la première électrode de transport de courant du cinquième transistor (18) étant couplée à la deuxième borne de sortie (26), la deuxième électrode de transport de courant du cinquième transistor (18) étant couplée à l'électrode de commande du quatrième transistor (12), et la troisième électrode de transport de courant du cinquième transistor (18) étant couplée à l'électrode de commande du cinquième transistor (18).

2. Circuit à pont en H (10) selon la revendication 1, où le deuxième circuit comporte un sixième transistor (14) qui possède des première, deuxième et troisième électrodes de transport de courant et une électrode de commande, la première électrode de transport de courant du sixième transistor (14) étant couplée à la première borne de sortie (20), la deuxième électrode de transport de courant du sixième transistor (14) étant couplée à l'électrode de commande du troisième transistor (22), et la troisième électrode de transport de courant du sixième transistor (14) étant couplée à l'électrode de commande du sixième transistor (14).

3. Circuit à pont en H (10) selon la revendication 2, où les premier, deuxième, troisième et quatrième transistors sont des transistors bipolaire NPN, et les cinquième et sixième transistors sont des transistors bipolaire PNP.

EP 0 527 641 B1

FIG. 1

*FIG. 2*

**FIG.3**